# EUROPEAN PATENT APPLICATION

(11) **EP 2 624 668 A1**
(43) Date of publication of application: **07.08.2013**
(21) Application number: 12185847.6
(22) Date of filing: 25.09.2012
(51) Int. Cl.: H05K 1/14, H05K 1/02, H05K 1/11

(54) **Integrated module, integrated system board, and electronic device**

(30) Priority: 17.01.2012 CN 201210013815
(71) Applicant: Huawei Device Co., Ltd., Longgang District Shenzhen Guangdong 518129 (CN)
(72) Inventor: Ding, Haixing, 518129 Shenzhen (CN); Xie, Guifu, 518129 Shenzhen (CN)
(74) Representative: Isarpatent

(57) **Abstract**

Embodiments of the present invention provide an integrated module. The integrated module includes a printed circuit board PCB and a modular device, where the modular device is mounted on the PCB; a group of front pin pads is disposed at four edges of a front surface of the PCB and the front pin pads are located around a mounted position of the modular device; and a group of bottom pin pads is disposed at four edges of a bottom surface of the PCB. Positions where the front pin pads are disposed are symmetric to positions where the bottom pin pads are disposed; and network properties of the front pin pads and those of the bottom pin pads are the same.

## Description

### FIELD OF THE INVENTION

The present invention relates to communications technologies, and in particular, to an integrated module, an integrated system board, and an electronic device.

### BACKGROUND OF THE INVENTION

With continuous development and advancement of science and technology, an integrated module with a high degree of integration is increasingly adopted in an electronic product in the communications field, where the integrated module is directly assembled to a mainboard of a whole machine, providing great convenience and generality to the applications of the whole machine. The design of an ordinary integrated module is generally a land grid array (Land Grid Array, LGA for short) or pinless chip carrier (Pinless Chip Carrier, LCC for short) castle-type packaging. The LGA is manufactured with electrode contacts in array status on a bottom surface, where metal contact packaging is adopted to replace original needle pins so as to overcome signal interference caused by the contact of pins. The LCC refers to surface mounted packaging where four sides of a ceramic baseboard only have electrode contacts but no pins, and is used to package a high-speed and high-frequency integrated circuit (Integrated Circuit, IC for short). Because the four sides in this packaging manner have no pins, a mounted area is relatively small and the height is relatively low. Generally, miniaturization packaging is further performed through the integrated module, that is, system in package, (System In Package, SIP for short) which is similar to package of a chip, is formed. In the prior art, the integrated module adopts a surface mounted technology (Surface Mounted Technology, SMT for short) to perform assembly, where a group of pin pads is designed at four edges of the bottom surface of a printed circuit board (Printed Circuit Board, PCB for short) of the integrated module, so as to mount a modular device on the front surface of the PCB.

However, when the integrated module in the prior art is tested, an additional line needs to be added to connect the integrated module and a test circuit, which increases the complexity of a test process.

### SUMMARY OF THE INVENTION

Embodiments of the present invention provide an integrated module, an integrated system board, and an electronic device, so as to improve the convenience for testing the integrated module without adding an additional test line.

In a first aspect, an embodiment of the present invention provides an integrated module, including a printed circuit board PCB and a modular device, where
the modular device is mounted on the PCB; a group of front pin pads is disposed at four edges of a front surface of the PCB and the front pin pads are located around a mounted position of the modular device; a group of bottom pin pads is disposed at four edges of a bottom surface of the PCB; and
positions where the front pin pads are disposed are symmetric to positions where the bottom pin pads are disposed; and network properties of the front pin pads and
those of the bottom pin pads are the same.

In another aspect, an embodiment of the present invention provides an integrated module, including a printed circuit board PCB and a modular device, where
the modular device and the PCB are plastically packaged into a whole body; a group of front pin pads is disposed at four edges of a front surface of the integrated module and the front pin pads are located around a mounted position of the modular device; a group of bottom pin pads is disposed at four edges of a bottom surface of the integrated module; and
positions where the front pin pads are disposed are symmetric to positions where the bottom pin pads are disposed; and network properties of the front pin pads and
those of the bottom pin pads are the same.

In another aspect, an embodiment of the present invention provides an integrated system board, including an integrated module and a mainboard, where the integrated module includes a printed circuit board PCB and a modular device;
the modular device is mounted on the PCB; a group of front pin pads is disposed at four edges of a front surface of the PCB; a group of bottom pin pads is disposed at four edges of a bottom surface of the PCB;
positions where the front pin pads are disposed are symmetric to positions where the bottom pin pads are disposed; and network properties of the front pin pads and
those of the bottom pin pads are the same; and
the mainboard is disposed with mainboard pin pads; and the integrated module is
assembled to the mainboard through the mainboard pin pads.

In still another aspect, an embodiment of the present invention provides an electronic device, including the foregoing integrated system board.

The technical effects according to the embodiments of the present invention are: a group of front pin pads is disposed at four edges of the front surface of the PCB, and a group of bottom pin pads is disposed at four edges of the bottom surface of the PCB, where the network properties of the front pin pads and those of the bottom pin pads are the same. Compared with the solution in the prior art, in the embodiments of the present invention, an additional test line does not need to be added, and the test may be performed directly through the front pin pads or the bottom pin pads, thereby improving the convenience of testing the integrated module; because both of the front pin pads and the bottom pin pads of the integrated module may be assembled to the mainboard, the embodiments improve the convenience of the assembly.

### BRIEF DESCRIPTION OF THE DRAWINGS

To illustrate the technical solutions in the embodiments of the present invention or in the prior art more clearly, accompanying drawings needed for describing the embodiments or the prior art are introduced briefly below. Apparently, the accompanying drawings in the following description merely show some embodiments of the present invention, and persons skilled in the art may further obtain other drawings according to the accompanying drawings without creative efforts.
FIG. 1 is a top view of an integrated module in a first integrated module embodiment of the present invention;
FIG. 2 is a bottom view of an integrated module in a first integrated module embodiment of the present invention;
FIG. 3 is a first schematic diagram of illustrating assembly between an integrated module and a mainboard in a first integrated module embodiment of the present invention;
FIG. 4 is a second schematic diagram of illustrating assembly between an integrated module and a mainboard in the first integrated module embodiment of the present invention;
FIG. 5 is a view of a front surface of an integrated module in a second integrated module embodiment of the present invention;
FIG. 6 is a view of a bottom surface of an integrated module in the second integrated module embodiment of the present invention;
FIG. 7 is a schematic structural diagram of a first embodiment of an integrated system board of the present invention; and
FIG. 8 is a schematic structural diagram of a second embodiment of an integrated system board of the present invention.

### DETAILED DESCRIPTION OF THE EMBODIMENTS

In order to make the objectives, technical solutions, and advantages of the present invention more comprehensible, the technical solutions of the embodiments of the present invention are clearly and completely described in the following with reference to the accompanying drawings. Apparently, the embodiments in the following description are merely a part rather than all of the embodiments of the present invention. All other embodiments obtained by persons skilled in the art based on the embodiments of the present invention without creative efforts shall fall within the protection scope of the present invention.

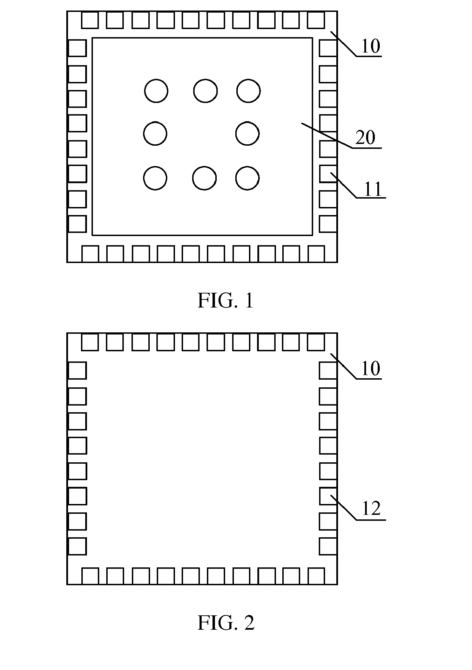

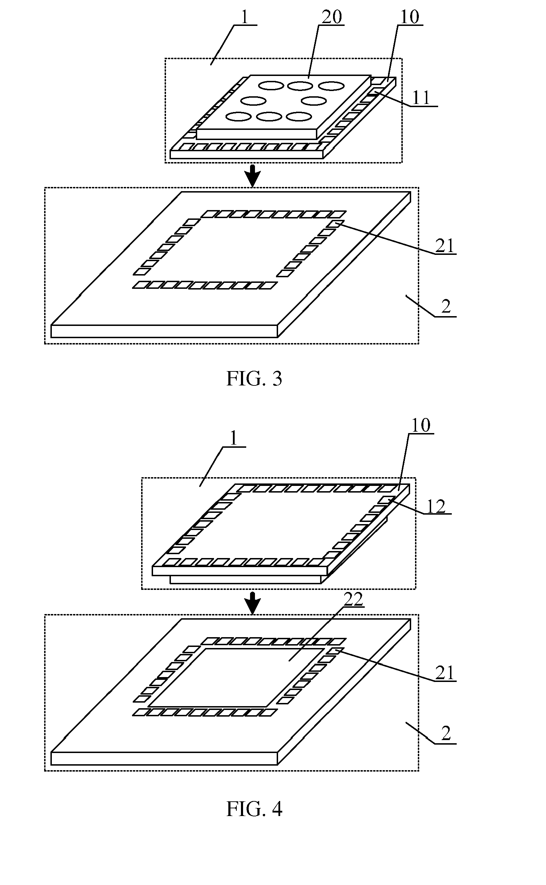

FIG. 1 and FIG. 2 are a top view and a bottom view of an integrated module in the first integrated module embodiment of the present invention respectively. As shown in FIG. 1 and FIG. 2, this embodiment provides an integrated module, which may specifically include a PCB 10 and a modular device 20. The modular device 20 is mounted on the PCB 10 by specifically adopting a mounting manner in the prior art, for example a mounting manner such as SMT. The modular device 20 is mounted on a front surface of the PCB 10, that is, one surface of the integrated module where the modular device 20 is mounted is the front surface, and then the other surface is a bottom surface of the integrated module. FIG. 1 is a top view of the integrated module, that is, a view seen from the front surface of the integrated module, while FIG. 2 is a bottom view of the integrated module, that is, a view seen from the bottom surface of the integrated module. Therefore, the modular device 20 mounted on the PCB 10 may be shown in FIG. 1, but cannot be shown in FIG. 2. In this embodiment, a group of front pin pads 11 is disposed at four edges of the front surface of the PCB 10, and the front pin pads 11 are located around a mounted position of the modular device 20, that is, the front pin pads are disposed around the mounted position of the modular device 20. A group of bottom pin pads 12 is disposed at four edges of the bottom surface of the PCB 10, and to be more specific, four edges here means being around the position of the modular device 20 mounted on the PCB 10. The modular device 20 is mounted within an area encircled by the front pin pads 11 or the bottom pin pads 12 on the PCB 10. In this embodiment, one of the front pin pads 11 and the bottom pin pads 12 is used to assemble the integrated module to a mainboard of an integrated system board; and the other one of the front pin pads 11 and the bottom pin pads 12 is used to test the pins. The integrated module is tested through the pins in a subsequent test process. In addition, in this embodiment, the positions where the front pin pads 11 are disposed are symmetric to the positions where the bottom pin pads are disposed, that is, the front pin pads 11 are disposed on the positions symmetric to the positions where the bottom pin pads 12 are disposed. In this embodiment, network properties of the front pin pads 11 and those of the bottom pin pads 12 are the same. Same network properties here refer to that each pin of newly added front pin pads 11 in the integrated module corresponds to each pin of the bottom pin pads 12 respectively, the structures and the functions of these two groups of pin pads are the same except the positions, and each pair of the corresponding pins are connected to each other. When the front pin pads 11 are assembled to the mainboard of the integrated system board, the bottom pin pads 12 may be used for a function test. When the bottom pin pads 12 are assembled to the mainboard of the integrated system board, the front pin pads 11 may be used for a function test. Therefore, when a test needs to be performed on the integrated module in this embodiment, an additional line does not need to be added to connect the integrated module and a test circuit, and the test may be directly performed on the pins of the front pin pads 11 or the pins of the bottom pin pads 12 that are used as test points. Specifically, FIG. 3 is a first schematic diagram of illustrating assembly between an integrated module and a mainboard in a first integrated module embodiment of the present invention. As shown in FIG. 3, in this embodiment, the bottom pin pads 12 (not shown) are specifically used to assemble an integrated module 1 to an integrated system board 2. Because a PCB 10 of the integrated module in FIG. 3 is right side up, and the bottom pin pads 12 are located on the bottom surface of the PCB 10 of the integrated module 1, the bottom pin pads 12 cannot be shown in FIG. 3. In this embodiment, the integrated module 1 and the mainboard 2 are assembled together through the bottom pin pads, and the front pin pads 11 may be used to test the integrated module 1, that is, serve as the test points for a function test.

Specifically, FIG. 4 is a second schematic diagram of illustrating assembly between an integrated module and a mainboard in a first integrated module embodiment of the present invention. As shown in FIG. 4, in this embodiment, front pin pads 11 (not shown) are used to assemble an integrated module 1 to a mainboard 2 of an integrated system board. Because a PCB 10 of the integrated module 1 in FIG. 4 is bottom up, and the front pin pads 11 are located on the front surface of the PCB 10 of the integrated module 1, the front pin pads 11 cannot be shown in FIG. 4. In this embodiment, the integrated module 1 and the mainboard 2 are assembled together through the front pin pads, and the bottom pin pads 12 are used to test the integrated module 1, that is, serve as the test points for a function test. It may be seen from FIG. 4 that, in this embodiment, the integrated module 1 is turned over and then assembled to the mainboard, and a modular device 20 is descended to an assembly slot 22 on the mainboard, so as to decrease the overall thickness of the integrated system board formed after the assembly.

This embodiment provides an integrated module. A group of front pin pads is disposed at four edges of the front surface of the PCB, and a group of bottom pin pads is disposed at four edges of the bottom surface of the PCB, where the network properties of the front pin pads and those of the bottom pin pads are the same. Compared with the solution in the prior art, in this embodiment, an additional test line does not need to be added, and the test may be performed directly through the front pin pads or the bottom pin pads, thereby improving the convenience of testing the integrated module; because both of the front pin pads and the bottom pin pads of the integrated module may be assembled to the mainboard, this embodiment improves the convenience of the assembly.

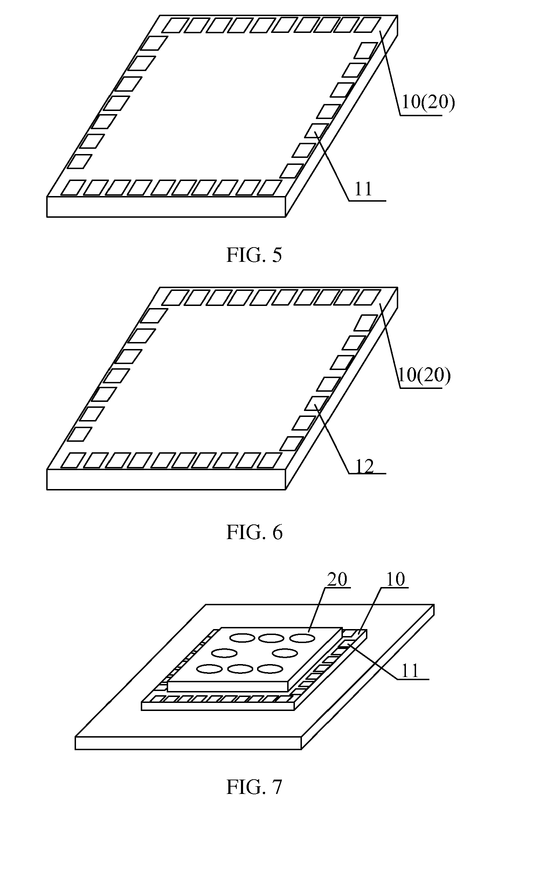

FIG. 5 and FIG. 6 are views of a front surface and a bottom surface of an integrated module respectively according to a second integrated module embodiment of the present invention. As shown in FIG. 5 and FIG. 6, this embodiment provides an integrated module, which may include a PCB 10 and a modular device 20. In this embodiment, the integrated module is a plastically packaged module, where the modular device 20 and the PCB 10 are plastically packaged into a whole body. In this embodiment, a group of front pin pads 11 is disposed at four edges of a front surface of the integrated module, and a group of bottom pin pads 12 is disposed at four edges of a bottom surface of the integrated module. The positions where the front pin pads 11 are disposed are symmetric to the positions where the bottom pin pads 12 are disposed, and network properties of the front pin pads and those of the bottom pin pads are the same.

Specifically, in this embodiment, the bottom pin pads 12 are specifically used to assemble the integrated module to a mainboard of an integrated system board. In this embodiment, the integrated module and the mainboard are assembled together through the bottom pin pads, and the front pin pads 11 are used to test the integrated module, that is, serve as the test points for a function test.

Specifically, in this embodiment, the front pin pads 11 are specifically used to assemble the integrated module to the mainboard of the integrated system board. In this embodiment, the integrated module and the mainboard are assembled together through the front pin pads, and the bottom pin pads 12 are used to test the integrated module, that is, serve as the test points for a function test.

This embodiment provides an integrated module. A group of front pin pads is disposed at four edges of the front surface of the integrated module, and a group of bottom pin pads is disposed at four edges of the bottom surface of the integrated module, where the network properties of the front pin pads and those of the bottom pin pads are the same. Compared with the solution in the prior art, in this embodiment, an additional test line does not need to be added, and the test may be performed directly through the front pin pads or the bottom pin pads, thereby improving the convenience of testing the integrated module; because both of the front pin pads and the bottom pin pads of the integrated module may be assembled to the mainboard, this embodiment improves the convenience of the assembly.

This embodiment further provides an integrated system board, which may specifically include an integrated module and a mainboard. The integrated module, specifically as shown in FIG. 1 and FIG. 2, includes a printed circuit board PCB 10 and a modular device 20, where the modular device 20 is mounted on the PCB 10, a group of front pin pads 11 is disposed at four edges of a front surface of the PCB 10, and a group of bottom pin pads 12 is disposed at four edges of a bottom surface of the PCB 10. In the PCB 10, the positions where the front pin pads 11 are disposed are symmetric to the positions where the bottom pin pads 12 are disposed, and network properties of the front pin pads 11 and those of the bottom pin pads 12 are the same. In this embodiment, the mainboard of the integrated system board is disposed with mainboard pin pads, and the integrated module is assembled to the mainboard through the mainboard pin pads.

FIG. 7 is a schematic structural diagram of a first embodiment of an integrated system board of the present invention. As shown in FIG. 7, this embodiment provides an integrated system board, which may specifically include an integrated module and a mainboard, where the integrated module includes a PCB 10 and a modular device 20. The structure of the integrated module may be shown in FIG. 1 or FIG. 2, and the manner that the integrated module is assembled to the mainboard is shown in FIG. 3. Still referring to FIG. 1, FIG. 2, and FIG. 3, the modular device 20 of the integrated module 1 is mounted on the PCB 10; a group of front pin pads 11 is disposed at four edges of the front surface of the PCB 10, and the front pin pads 11 are located around the mounted position of the modular device 20, that is, the front pin pads are disposed around the mounted position of the modular device 20; a group of bottom pin pads 12 is disposed at four edges of the bottom surface of the PCB 10, and the positions where the front pin pads 11 are disposed are symmetric to the positions where the bottom pin pads 12 are disposed; the network properties of the front pin pads 11 and those of the bottom pin pads 12 are the same. In this embodiment, the mainboard 2 of the integrated system board is disposed with mainboard pin pads 21, and the mainboard pin pads 21 are used to assemble the integrated module 1 to the mainboard 2. It may be seen from FIG. 3 that, in this embodiment, the integrated module in the assembled integrated system board is right side up. In this embodiment, the bottom pin pads of the integrated module 1 and the mainboard pin pads 21 on the mainboard 2 are soldered together, so as to realize that the integrated module 1 is assembled to the mainboard 2. In this embodiment, the front pin pads 11 of the integrated module 1 are used to test the integrated module, so as to export the bottom pin pads without adding an additional test connection circuit.

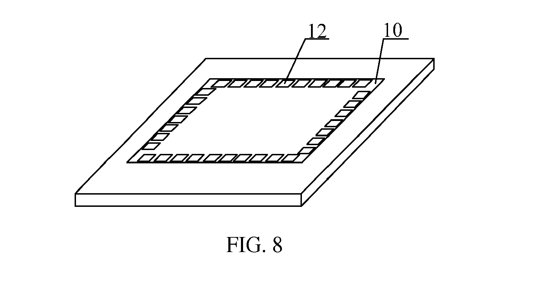

FIG. 8 is a schematic structural diagram of a second embodiment of an integrated system board of the present invention. As shown in FIG. 8, this embodiment provides an integrated system board, which may specifically include an integrated module and a mainboard, where the integrated module includes a PCB 10 and a modular device 20. The structure of the integrated module may be shown in FIG. 1 or FIG. 2, and the manner that the integrated module is assembled to the mainboard may be shown in FIG. 4. Still referring to FIG. 1, FIG. 2, and FIG. 4, the modular device 20 of the integrated module 1 is mounted on the PCB 10; a group of front pin pads 11 is disposed at four edges of the front surface of the PCB 10, a group of bottom pin pads 12 is disposed at four edges of the bottom surface of the PCB 10, and the positions where the front pin pads 11 are disposed are symmetric to the positions where the bottom pin pads 12 are disposed; and the network properties of the front pin pads 11 and those of the bottom pin pads 12 are the same. In this embodiment, the mainboard 2 of the integrated system board is disposed with mainboard pin pads 21, and the mainboard pin pads 21 are used to assemble the integrated module 1 to the mainboard 2.

In addition, in this embodiment, the mainboard 2 is disposed with the assembly slot 22, and the assembly slot 22 is opened within an area encircled by the mainboard pin pads 21. It may be seen from FIG. 4 that, in this embodiment, the integrated module 1 in the assembled integrated system board faces down, that is, in this embodiment, the integrated module 1 is turned over and then assembled to the mainboard 2, and the mainboard 2 is disposed with the assembly slot 22 that matches the modular device 20. In this embodiment, the integrated module 1 faces down; the front pin pads of the integrated module 1 and the mainboard pin pads 21 of the mainboard 2 are soldered together; the modular device 20 is disposed in a penetration manner in the assembly slot 22 disposed on the mainboard 2, the penetration here means that the size of the assembly slot 22 matches that of the modular device 20, and the modular device 20 located on the PCB 10 is descended into the assembly slot 22 exactly, so that the integrated module 1 passes through the assembly slot 22 and then is assembled to the mainboard 2. It may be seen from FIG. 8 that, compared with the conventional assembly manner in which the integrated module is right side up as shown in FIG. 7, the manner in this embodiment enables the overall thickness of the assembled integrated system board to be obviously decreased, which is equivalent to that the thickness of the modular device is decreased. In this embodiment, the bottom pin pads 12 of the integrated module 1 are used to test the integrated module, so as to export the bottom pin pads without adding an additional test connection circuit.

This embodiment provides an integrated system board, which is formed of an integrated module and a mainboard. A group of front pin pads is disposed at four edges of the front surface of the PCB of the integrated module, and a group of bottom pin pads is disposed at four edges of the bottom surface of the PCB, where the network properties of the front pin pads and those of the bottom pin pads are the same. Compared with the solution in the prior art, in this embodiment, an additional test line does not need to be added, and the test may be performed directly through the front pin pads or the bottom pin pads, thereby improving the convenience of testing the integrated module. In addition, in this embodiment, pin pads are disposed on both the front surface and the bottom surface of the integrated module, so as to implement two assembly manners of the integrated system board. Moreover, the assembly manner in which the integrated module faces down may obviously decreases the overall thickness of the integrated system board, so as to implement the miniaturization of the electronic device.

This embodiment further provides an electronic device, which may specifically include the integrated system board shown in FIG. 7 or FIG. 8.

Finally, it should be noted that the embodiments are merely provided for describing the technical solutions of the present invention, but not intended to limit the present invention. It should be understood by persons skilled in the art that although the present invention has been described in detail with reference to the embodiments, modifications may be made to the technical solutions described in the embodiments, or equivalent replacements may be made to some or all the technical features in the technical solutions, as long as such modifications or replacements do not depart from the scope of the technical solutions of the embodiments of the present invention.

## Claims

1. An integrated module, **characterized by** comprising a printed circuit board PCB (10) and a modular device (20), wherein
the modular device is mounted on the PCB; a group of front pin pads (11) is disposed at four edges of a front surface of the PCB and the front pin pads are located around a mounted position of the modular device; a group of bottom pin pads (12) is disposed at four edges of a bottom surface of the PCB; and
positions where the front pin pads are disposed are symmetric to positions where the bottom pin pads are disposed; and network properties of the front pin pads and those of the bottom pin pads are the same.

2. The integrated module according to claim 1, wherein the bottom pin pads are used to assemble the integrated module to a mainboard of an integrated system board, and the front pin pads are used to test the integrated module.

3. The integrated module according to claim 1, wherein the front pin pads are used to assemble the integrated module to a mainboard of an integrated system board, and the bottom pin pads are used to test the integrated module.

4. An integrated system board, comprising an integrated module (1) according to any one of the claims 1 to 3 and a mainboard (2), wherein
the mainboard is disposed with mainboard pin pads (21); and the integrated module is assembled to the mainboard through the mainboard pin pads.

5. The integrated system board according to claim 4, wherein the integrated module is assembled to the mainboard through a soldering connection between the mainboard pin pads and the bottom pin pads; and
the front pin pads are used to test the integrated module.

6. The integrated system board according to claim 4, wherein the mainboard is disposed with an assembly slot (22), and the assembly slot is opened within an area encircled by the mainboard pin pads;
the integrated module is assembled to the mainboard through a soldering connection between the mainboard pin pads and the front pin pads, and the modular device is disposed in a penetration manner in the assembly slot disposed on the mainboard; and
the bottom pin pads are used to test the integrated module.

7. An electronic device, comprising the integrated system board according to any one of claims 4 to 6.

8. An integrated module, **characterized by** comprising a printed circuit board PCB and a modular device, wherein
the modular device and the PCB are plastically packaged into a whole body; a group of front pin pads is disposed at four edges of a front surface of the integrated module; a group of bottom pin pads is disposed at four edges of a bottom surface of the integrated module; and
positions where the front pin pads are disposed are symmetric to positions where the bottom pin pads are disposed; and network properties of the front pin pads and those of the bottom pin pads are the same.

9. The integrated module according to claim 8, wherein the bottom pin pads are used to assemble the integrated module to a mainboard of an integrated system board; and the front pin pads are used to test the integrated module.

10. The integrated module according to claim 8, wherein the front pin pads are used to assemble the integrated module to a mainboard of an integrated system board; and the bottom pin pads are used to test the integrated module.
